(19) Europäisches Patentamt
European Patent Office
Office européen des brevets

(11) **EP 0 675 604 B1**

(12) **EUROPÄISCHE PATENTSCHRIFT**

(45) Veröffentlichungstag und Bekanntmachung des Hinweises auf die Patenterteilung:
**09.12.1998 Patentblatt 1998/50**

(51) Int Cl.$^6$: **H03M 3/02**, H03M 1/48

(21) Anmeldenummer: **95101247.5**

(22) Anmeldetag: **30.01.1995**

(54) **Integrierender Analog-Digital-Umsetzer**

Integrating analog-digital converter

Convertisseur analogique-numérique à intégration

(84) Benannte Vertragsstaaten:
**AT BE CH DE FR GB IT LI**

(30) Priorität: **24.03.1994 EP 94104741**

(43) Veröffentlichungstag der Anmeldung:
**04.10.1995 Patentblatt 1995/40**

(73) Patentinhaber: **SIEMENS AKTIENGESELLSCHAFT 80333 München (DE)**

(72) Erfinder:
• **Mertens, Axel, Dr. D-91083 Baiersdorf (DE)**
• **Eckardt, Dieter, Dr. D-91074 Herzogenaurach (DE)**

(56) Entgegenhaltungen:
**US-A- 4 672 361**

• **ELECTRONICS LETTERS, Bd.27, Nr.22, 24. Oktober 1991, STEVENAGE, HERTS. GB Seiten 2008 - 2009, XP000253717 ZHANG ET AL 'bandpass delta-sigma A/D converter using two-path multibit structure'**

**Beschreibung**

Die Erfindung bezieht sich auf einen integrierenden Analog-Digital-Umsetzer, der eine Reihenschaltung eines analogen Integrators, eines A/D-Wandlers und einer synchronen Abtastung aufweist, wobei die Reihenschaltung eingangsseitig mit einem Ausgang eines Vergleichers und ausgangsseitig über einen D/A-Wandler mit einem negativen Eingang dieses Vergleichers verbunden ist, an dessen positivem Eingang eine analoge Eingangsgröße ansteht.

In der Antriebstechnik werden beispielsweise für die Erfassung der Stromistwerte vorteilhaft integrierende A/D-Wandler eingesetzt, um die stets vorhandenen Oberschwingungen wirkungsvoll dämpfen zu können.

Dazu ist es erforderlich, daß das Integrationsintervall frei gewählt werden kann und bei einer Integrationslänge von etwa 250 µs eine Genauigkeit von beispielsweise 12 Bit resultiert.

Das Wandlungssystem sollte sich ferner im Hinblick auf eine dezentrale Datenerfassung in zwei Teilsysteme zerlegen lassen, die durch eine einzige Übertragungsleitung miteinander gekoppelt werden können. Die auftretenden Übertragungsraten sollten maximal etwa 5 MBaud nicht überschreiten, um den Einsatz preiswerter Sender- und Empfänger-Bausteine für Lichtleiterkabel zu ermöglichen.

Außerdem muß bei dezentralen Anwendungen die Übertragung eines Grenzwertmeldesignals möglich sein. Schließlich sollte das System preiswert zu realisieren und gut zu integrieren sein, beispielsweise in einem kundenspezifisch integrierten Baustein (ASIC), und eine Korrektur der Meßwerte in einem weiteren Prozessor nicht erforderlich sein.

Bisher wurden zu diesem Zweck U/f-Umsetzer verwendet. Die verwendeten U/f-Umsetzer können diese aufgeführten Forderungen nur zum Teil erfüllen. Insbesondere ist hier in der Regel eine Korrektur in einem nachgeschalteten Prozessorsystem hinsichtlich Nullpunkt und Übertragungsbeiwert erforderlich. Ferner ist die Übertragung eines Grenzwertsignals über den gleichen Übertragungskanal wie das Frequenzsignal praktisch ausgeschlossen, da eine Identifizierung auf der Empfangerseite zumindest sehr aufwendig ist.

Die verwendete Mittenfrequenz von 60 kHz bei einem Frequenzhub von 30 kHz läßt nur eine Rasterung je nach Ausgangsfrequenz von 11 µs bis 33 µs zu, wodurch sich eine mangelnde Unterdrückung der Oberwellen in Fehlern des Wandlungsergebnisses wiederspiegelt, so daß die Meßgenauigkeit auf 8 bis 10 Bit beschränkt bleibt.

Aus der EP 0 387 686 A2 ist ein Verfahren zur Spannungs-Frequenz-Wandlung und einer Einrichtung zur Durchführung des Verfahrens bekannt, mit dem sich mit einfachen Mitteln eine äußerst schnelle und hochgenaue Digitalisierung eines Eingangssignals bei großen Frequenzhubbereichen erreichen läßt. Eine in den positiven Bereich angehobene Eingangsspannung wird integriert und als integrierte Spannung mit einer in äquidistanten Schritten veränderlichen Referenzspannung verglichen. Mit der daraus resultierenden Differenzspannung wird über ein Regelglied ein spannungsgesteuerter Oszillator beaufschlagt, der eine der Ausgangsspannung des Regelgliedes proportionale Pulsfolgefrequenz abgibt. Mit jedem Impuls wird die Referenzspannung inkrementiert, so daß diese treppenförmig der integrierten Spannung folgt. Die Impulsfolgefrequenz der durch den spannungsgesteuerten Oszillator erzeugten Impulse ist damit proportional der Eingangsspannung. Somit erhalt man einen Spannungs-Frequenz-Umsetzer, der bei einer Mittenfrequenz von 10 MHz bis 15 MHz und einem Frequenzhub von 9 MHz bis 14 MHz arbeitet. Ein Grenzwertsignal läßt sich aber nicht übertragen.

Aus der Literatur ist aber auch ein anderes integrierendes Wandlungsverfahren bekannt, das sogenannte Sigma-Delta-Verfahren. Im Oberbegriff des Anspruchs 1 ist ein sogenannter Sigma-Delta-A/D-Umsetzer mit seinen Komponenten angegeben.

Der A/D-Wandler eines solchen Sigma-Delta-A/D-Umsetzers benötigt in seiner üblichen Realisierung $2^N$-1 Komparatoren. Die Arbeitsbewegung des Signals am Integratorausgang umfaßt den gesamten Eingangsspannungsbereich des A/D-Wandlers. Der D/A-Wandler des Sigma-Delta-A/D-Umsetzers wird üblicherweise mit einem geschalteten Widerstandsnetzwerk realisiert. Seine Genauigkeit bestimmt die Genauigkeit des Sigma-Delta-A/D-Umsetzers. Auch durch eine nachfolgende Filterung läßt sich die Genauigkeit des Sigma-Delta-A/D-Umsetzers nicht über die seines D/A-Wandlers hinaus erhöhen.

Handelsübliche Ausführungen eines Sigma-Delta-A/D-Umsetzers sind für den vorliegenden Anwendungsbereich (Antriebstechnik) jedoch nicht brauchbar, da diese Wandler zur Erzielung der gewünschten hohen Auflösung zu lange Integrationszeiten benötigen, woraus eine zu kleine obere Eckfrequenz des Wandlersystems resultiert. Darüberhinaus kann die Integrationslänge bei diesen Bausteinen in der Regel nicht frei gewählt werden. Der Sigma-Delta-A/D-Umsetzer ist aber wegen seines einfachen Aufbaus und guter Integrierbarkeit interessant.

Digital-Analog-Wandler werden dann eingesetzt, wenn in digitaler Form vorliegende Werte in analoge Werte umzuwandeln sind. Die Breite der zu wandelnden Binärsignale hängt dabei wesentlich von der jeweils vorliegenden Hardware, z.B. dem jeweils verwendeten Prozessor ab. Momentan sind digitale Signale häufig als 16 Bit breite Binärsignale vorhanden. Digital-Analog-Wandler für derart feine Auflösungen sind jedoch technisch relativ aufwendig und damit dementsprechend teuer. Es sind aber auch weniger aufwendige Digital-Analog-Wandler am Markt vorhanden, die eine geringere Auflösung von 8 Bit aufweisen. Wenn jedoch Digital-Signale mit mehr als 8 Bit Breite eine Wandlung über einen Digital-Analog-Wandler mit nur 8 Bit Breite erfahren, so muß ein Auflösungsverlust in Kauf genommen werden.

Andernfalls bleibt nur die Möglichkeit, auf die wesentlich teueren höherauflösenden Digital-Analog-Wandler zurückzugreifen.

Aus der EP 0 477 407 A1 ist eine Einrichtung zum Umsetzen eines m-Bit breiten Binärsignals in ein Analogsignal unter Verwendung eines n-Bit breiten Digital-Analog-Wandlers bekannt, wobei m größer als n ist. Bei dieser Einrichtung bilden die n höchstwertigen Bits des Binärsignals ein Basis-Binärsignal, wobei die m-n niederwertigen Bits des Binärsignals ein Ergänzungs-Binärsignal bilden. Diese Einrichtung weist Mittel zum Wichten der Lage des Erganzungs-Binärsignals innerhalb des möglichen Bereichs für das Ergänzungs-Binärsignal auf. Entsprechend dem Wichtungsergebnis wird ein pulsbreitenmoduliertes Signal ermittelt, gemäß dem das Basis-Binärsignal jeweils für die Dauer jedes Impulses kurzzeitig auf einen um einen Quantisierungssprung erhöhten Wert angehoben wird.

Mittels diesem Verfahren erhöht sich die Auflösung des Ausgangssignals des D/A-Wandlers in der Weise, daß die einzelnen Stufen durch eine Pulsbreitenmodulation entsprechend der Feinheit des zugeführten Digitalsignals variiert werden können, so daß sich fiktive Zwischenstufen ergeben.

Als Mittel zum Bilden des pulsbreitenmodulierten Signals ist ein Taktgeber, eine Zahl stufe und ein Vergleicher vorgesehen, wobei die Zahlstufe eine Zählbreite von m-n Bit aufweist und zyklisch durch den Taktgeber fortgeschaltet wird, und wobei der Vergleicher das Ergänzungs-Binärsignal und den Zählerstand der Zählstufe miteinander vergleicht und dann, wenn das Ergänzungs-Binärsignal größer ist als der Zählerstand, ein Signal Logisch "1" und andernfalls ein Signal Logisch "0" liefert, das in einem Summierglied zum Basis-Binärsignal addiert wird, wobei das Ausgangssignal des Summiergliedes als Eingangssignal für den Digital-Analog-Wandler dient. Damit ist eine schaltungstechnisch ausgesprochen einfache Möglichkeit einer Pulsbreitenmodulation möglich.

Der Erfindung liegt nun die Aufgabe zugrunde, einen integrierenden Analog-Digital-Wandler gemaß Oberbegriff so weiterzubilden, daß dieser Wandler eine hohe Genauigkeit bei frei wählbarer Integrationszeit und -grenzen erhält, wobei der Aufwand kostengünstig und platzsparend mit einer hohen Störfestigkeit sein soll.

Diese Aufgabe wird erfindungsgemäß mit den Merkmalen des Anspruchs 1 gelöst.

Durch die erfindungsgemäße Ausgestaltung des A/D-Wandlers des integrierenden Analog-Digital-Umsetzers verringert sich der Aufwand für diesen A/D-Wandler erheblich. Der Ausgang dieses A/D-Wandlers entspricht der Summe eines Ausgangssignals eines 1-Bit-A/D-Wandlers und eines gespeicherten digitalen N-Bit-Wertes. Verläßt die Ausgangsspannung des analogen Integrators des integrierenden Analog-Digital-Umsetzers den normalen Arbeitsbereich um Null Volt, so wird der gespeicherte Digitalwert mittels des N-Bit-A/D-Wandlers um eins erhöht oder erniedrigt. Damit bleibt die Ausgangsspannung des analogen Integrators immer in der Nähe von Null Volt.

Mit dieser Ausgestaltung des A/D-Wandlers des integrierenden Analog-Digital-Umsetzers wird eine Grobquantisierung vorgenommen, wobei nur noch eine Interpolation zwischen jeweils benachbarten Grobquantisierungsstufen durchgeführt wird.

Der Unterschied ist jedoch, daß die rückgekoppelte Spannung (Ausgangsspannung des D/A-Wandlers des integrierenden Analog-Digital-Umsetzers) im stationären Fall nur um maximal eine Quantisierungsstufe des D/A-Wandlers neben der analogen zu digitalisierenden Eingangsspannung liegt. Die Schalthandlungen des Zweipunktreglers führen jetzt im rückgekoppelten Signal nur zu Änderungen in der Größe der Quantisierungsstufe.

Der N-Bit-breite A/D-Wandler hingegen geht in die statische Genauigkeit nicht ein, wenn die Integrationskonstante so gewählt wird, daß das Ausgangssignal des analogen Integrators stets kleiner als eine Quantisierungsstufe des A/D-Wandlers ist. Dann liefert der A/D-Wandler an seinem Ausgang im stationären Zustand stets den Wert Null und der Inhalt des nachgeschalteten digitalen Integrators bleibt unverändert. Dieser Integrator dient zum im Mittel stationär genauen Ausregeln der Ausgangsspannung des analogen Integrators auf den Wert Null.

Ein Unterschied zu dem eingangs genannten Sigma-Delta-A/D-Umsetzer besteht im Aussehen der Folge p(k) (digitales Ausgangssignal des Umsetzers). Diese Folge kann jetzt je nach Anzahl der Quantisierungsstufen ($2^L$-1) des D/A-Wandlers bis zu $2^L$ verschiedene Werte annehmen.

Das bedeutet, daß mittels dem erfindungsgemäßen integrierenden Analog-Digital-Umsetzers mehrstellige Dual-Zahlenwerte entstehen, die seriell über eine eindrähtige Übertragungsstrecke gesendet werden können, wobei die Wichtung der einzelnen Stellen dabei erhalten bleiben muß.

In einer vorteilhaften Ausführungsform des erfindungsgemäßen integrierenden Analog-Digital-Umsetzers wird als N-Bit-A/D-Wandler ein Dreipunktschalter verwendet. Dadurch erhält man eine besonders einfache Ausführungsform. Da, wie vorstehend festgestellt wurde, der N-Bit-A/D-Wandler des integrierenden Analog-Digital-Umsetzers keinen Einfluß auf die stationäre Genauigkeit besitzt, ist die einfachste Ausführungsform ein Dreipunktregler. Die Schaltschwellen müssen dabei so gelegt werden, daß die durch den Zweipunktregler verursachte Arbeitsbewegung stets im Intervall zwischen den beiden Schaltschwellen des Dreipunktschalters bleibt. Lediglich, wenn das Eingangssignal zu groß oder zu klein geworden ist, so daß der Zweipunktregler das benötigte Stellsignal nicht mehr aufbringen kann, läuft der analoge Integrator weg und überschreitet die obere bzw. untere Schaltschwelle. In diesem Falle wird dann der nachgeschaltete digitale Integrator um eins erhöht oder erniedrigt.

Bei einer weiteren vorteilhaften Ausführungsform des erfindungsgemäßen integrierenden Analog-Digital-Umsetzers wird der im Rückkopplungszweig befindliche D/A-Wandler durch eine Einrichtung zur Erzeugung eines pulsdauermodulierten Signals aus einem n-Bit-Ausgangssignal ersetzt. Diese Einrichtung läßt sich mittels einer quarzstabilisierten Taktfrequenz hochgenau und mit geringem Aufwand realisieren. Auch wenn sich dadurch das Ausgangssignal des analogen Integrators gegenüber dem bekannten Sigma-Delta-A/D-Umsetzer stark verändert, bleibt das Funktionsprinzip dieses Umsetzers erhalten, weil nur der Mittelwert der Differenz zwischen Eingangs- und Ausgangssignal über eine Abtastperiode ausgewertet wird.

Die erzielbare Genauigkeit hängt von der Präzision der Spannungs-Zeit-Flächen am Ausgang der PWM-Einrichtung ab. Um die Spannungsamplitude konstant zu halten, wird das PWM-Schaltglied aus einer Referenzspannungsquelle versorgt.

Unterschiedliche Schaltzeiten und Flankensteilheiten bei den positiven und negativen Signalflanken führen zu Fehlern. Treten dadurch in jeder Abtastperiode dieselben Fehlerflächen auf, so führen diese jedoch nur zu einem Offset und nicht zu einer Nichtlinearität. Daher wird das PWM-Signal so ausgeführt, daß in jeder Abtastperiode eine feste Zahl von Schaltspielen auftritt. Um den Schaltelementen eine Mindesteinschalt- und Ausschaltdauer zu gewähren, wird das Signal zu Beginn der Abtastperiode für einige Takte zu eins und am Ende der Abtastperiode für einige Takte zu Null gesetzt. Damit ist auch sichergestellt, daß zum Zeitpunkt der Abtastung keine Schaltvorgänge auftreten.

Werden der A/D-Wandler und der D/A-Wandler des integrierenden Analog-Digital-Umsetzers erfindungsgemäß aufgebaut, so erhält man eine bevorzugte Ausführungsform des erfindungsgemäßen Umsetzers.

Zur Erweiterung des Dynamikbereichs dieser bevorzugten Ausführungsform kann anstelle des Dreipunktreglers ein Fünfpunktregler als N-Bit-A/D-Wandler vorgesehen sein. D.h., da der Dreipunktregler mittels dreier Komparatoren aufgebaut ist, benötigt man nur zwei weitere Komparatoren. Verläßt nun das Ausgangssignal des analogen Integrators den somit erweiterten Spannungsbereich, so wird der digital gespeicherte n-Bit-Wert im digitalen Integrator um mehr als eins, z.B. um zwei, verändert. Durch zwei zusätzliche Komparatoren läßt sich somit der Dynamikbereich mindestens verdoppeln. Das Prinzip läßt sich mit weiteren Komparatoren entsprechend fortführen.

Bei einer vorteilhaften Ausführungsform des erfindungsgemäßen integrierenden Analog-Digital-Umsetzers sind der Zweipunktregler, der digitale Integrator des A/D-Wandlers und die PWM-Einrichtung des D/A-Wandlers in einem Digitalbaustein, beispielsweise einem kundenspezifischen integrierten Baustein (ASIC) integriert. Dadurch erhält man einen besonders einfachen Aufbau des erfindungsgemäßen Umsetzers, der sich in einen analogen und einen digitalen Teil unterteilt. Der analoge Teil besteht lediglich aus zwei Operationsverstärkern, wenigstens drei Komparatoren, einer Referenzspannungsquelle und zwei Treibern, wobei der Digitalteil in Form eines ASIC kostengünstig realisiert wird.

Es kann auch das gesamte System in einem ASIC integriert werden, also Analogteil und Digitalteil auf einem Chip.

Zur näheren Erläuterung der Erfindung wird auf die Zeichnung bezug genommen, in der mehrere Ausführungsbeispiele des erfindungsgemäßen integrierenden Analog-Digital-Umsetzers schematisch veranschaulicht sind.

| | |
|---|---|
| Figur 1 | zeigt ein Blockschaltbild eines bekannten Sigma-Delta-A/D-Umsetzers, |
| Figur 2 | zeigt ein Blockschaltbild einer ersten Ausführungsform des erfindungsgemäßen Umsetzers, wobei in |
| Figur 3 | ein Blockschaltbild einer zweiten Ausführungsform des erfindungsgemäßen Umsetzers dargestellt ist, die |
| Figur 4 | zeigt die Realisierung einer vorteilhaften Ausführungsform des erfindungsgemäßen Umsetzers, die |
| Figur 5 | zeigt die Realisierung einer besonders vorteilhaften Ausführungsform des erfindungsgemäßen Umsetzers, die |
| Figur 6 | zeigt ein Blockschaltbild einer Mittelwertbildung mit variablen Zeitgrenzen, und in der |
| Figur 7 | ist ein Blockschaltbild eines Systems zur dezentralen Istwerterfassung dargestellt, wobei in der |
| Figur 8 | ein Blockschaltbild der zugehörigen seriellen Datenübertragung veranschaulicht ist. |

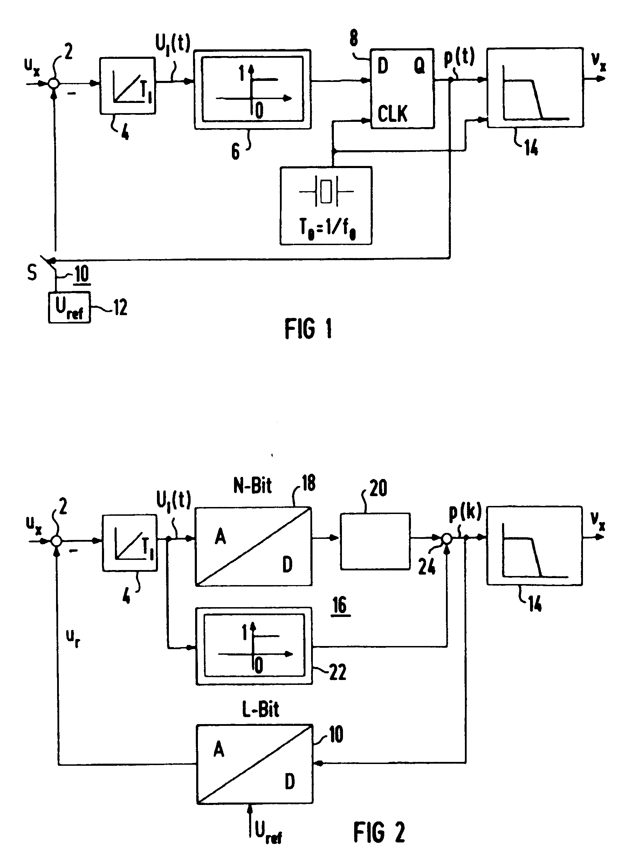

Die Figur 1 zeigt ein Blockschaltbild eines bekannten Sigma-Delta-A/D-Umsetzers. Dieser besteht aus den Komponenten Vergleicher 2, analoger Integrator 4, A/D-Wandler 6, synchrone Abtastung 8 und D/A-Wandler 10. Als A/D-Wandler 6 ist ein Zweipunktschalter, beispielsweise ein Komparator, und als synchrone Abtastung 8 ist ein D-Flip-Flop vorgesehen. Der D/A-Wandler 10 ist mittels einer Referenzspannungsquelle 12 und einem Schalter S realisiert. Am Ausgang entsteht eine Folge p(t) von Meßwerten mit 1-Bit Auflösung in zeitlichen Abständen von z.B. einer 1 µs. Durch eine nachfolgende digitale Filterung mittels eines digitalen Tiefpasses 14 können aus dieser Folge genauere Meßwerte mit mehr als 1-Bit Auflösung in größeren Zeitabständen ermittelt werden. Der analoge Integrator integriert die unbekannte Eingangsspannung $u_x \geq 0$ ständig. Das Vorzeichen der Ausgangsspannung des Integrators 4 wird von dem Zweipunktschalter ermittelt und taktsynchron in dem D-Flip-Flop 8 übernommen. Je nach dem Wert des Ausgangssignals des D-Flip-Flops 8 bzw. der Folge p(t) wird der Schalter S des D/A-Wandlers 10 betätigt und die Referenzspannung $U_{ref}$ zusätzlich mittels des Vergleichers 2 an den Eingang des Integrators 4 gelegt, um dessen Inhalt wieder zu verkleinern. Die Folge p(t) behält aufgrund des taktsynchronen Betriebs immer für genau eine Taktperiode $T_0$ seinen Wert bei. Das Integrationsausgangssignal $U_I(t)$ berechnet sich mit der Integrationszeit $T_M$ zu:

$$U_I(T_M) = \frac{1}{T_I} \int_0^{T_M} (u_x(t) - u_{ref} \cdot p(t))\,dt + U_I(0)$$

$$(1)$$

Da die Folge p(t) stückweise konstant ist, und nur die Werte 0 oder 1 annehmen kann, läßt sich mit der Integrationslänge $T_M = M \cdot T_0$ der Integrationsinhalt auch gemäß

$$U_I(T_M) = \frac{1}{T_I} \int_0^{T_M} u_x(t)\,dt - \frac{U_{ref}}{T_I} \cdot \sum_{k=0}^{M-1} p(k \cdot T_0) \cdot T_0 + U_I(0)$$

$$(2)$$

angeben.

An dieser Stelle sei darauf hingewiesen, daß alle nachfolgenden Betrachtungen nur noch für hinreichend große M durchgeführt werden. Diese Einschränkung ist für die Praxis irrelevant, die Übersichtlichkeit erhöht sich jedoch.

Der Integrator 4 und der Zweipunktschalter 6 bilden zusammen mit dem Schalter S einen Regelkreis, der bestrebt ist, den Integratorinhalt auf dem Wert 0 zu halten. Deshalb darf idealisiert $U_I(0) = U_I(t) = 0$ gesetzt werden, und es wird

$$\frac{1}{T_M} \int_0^{T_M} u_x(t)\,dt = U_{ref} \cdot \frac{1}{T_M} \sum_{k=0}^{M-1} p(k \cdot T_0) \cdot T_0$$

$$(3)$$

oder

$$\frac{1}{T_M} \int_0^{T_M} u_x(t)(dt) = U_{ref} \cdot \frac{1}{M} \sum_{k=0}^{M-1} p(k \cdot T_0)$$

$$(4)$$

das heißt, der Mittelwert der unbekannten Eingangsspannung $u_x(t) \geq 0$ wird auf dem Mittelwert der Folge $p(k \cdot T_0)$ abgebildet. Zur Vereinfachung wird anstelle $p(k \cdot T_0)$ auch nur p(k) verwendet, wenn Verwechslungen ausgeschlossen sind.

Das in Figur 1 dargestellte Tiefpaßfilter 14 muß daher genau die Beziehung

$$\upsilon_x = \frac{1}{M} \sum_{k=0}^{M-1} p(k)$$

$$(5)$$

realisieren, um den gewünschten Wandlungseffekt zu generieren.

Die auftretende Arbeitsbewegung des Integrators 4 läßt sich noch über die Integrierzeitkonstante $T_I$ beeinflussen, wodurch sich am Ergebnis aber nichts ändert. Der Wandler arbeitet, wie dies auch durch Gleichung (5) zum Ausdruck kommt, unabhängig von der Integrierzeitkonstante $T_I$.

Anhand der Arbeitsbewegung kann die Auflösung bzw. die maximal erreichbare Genauigkeit ermittelt werden. Diese ist dann erreicht, wenn im Meßintervall nur noch $p(0) = 1$ und $p(k) = 0$ für $k > 0$ ist, also im Meßintervall nur noch ein Abtastwert der Folge $p(k)$ von Null verschieden ist.

Damit wird aus Gleichung (4)

$$\frac{1}{T_M} \int_0^{T_M} u_{x\,min}\, dt = \frac{1}{M} \cdot U_{ref} \qquad (6)$$

Für $u_{xmin}$ = konstant wird

$$u_{x\,min} = \frac{U_{ref}}{M} \qquad (7)$$

Die Auflösung in Bit ergibt sich somit gemäß

$$\text{Auflösung [Bit]} = ld\,(M) \qquad (8)$$

Der Wandler hat also 8 Bit Auflösung, wenn $M = 256$.

Geht man davon aus, daß der Impuls bei $k = M$, der zum Rückstellen des Integrators 4 dient, jetzt schon bei $k = M-1$ auftritt, dann fällt er noch in das betrachtete Intervall und wird mitgezählt. Der absolute Wandlungsfehler beträgt also maximal

$$\Delta u_x = \frac{U_{ref}}{M} \qquad (9)$$

wenn immer nur das Intervall der Länge M betrachtet wird. Der absolute Meßfehler beträgt also

$$\text{abs.Meßfehler} = \pm \frac{1}{M} \qquad (10)$$

oder $\pm$ 1LSB (least significant bit).

Bei einer gewünschten Genauigkeit von 12 Bit wäre somit mindestens eine Mittelungslänge M = 4096 erforderlich. Soll die Bei einer gewünschten Genauigkeit von 12 Bit ware somit mindestens eine Mittelungslänge M = 4096 erforderlich. Soll die Zeit $T_M = M \cdot T_0$ beim Wert 256 µs liegen, folgt eine notwendige Taktfrequenz $^1/_{T_0}$ = 16 MHz.

Abgesehen von den bereits erläuterten Problemen bei der Übertragung des Datenstromes und der fehlenden Möglichkeit, Grenzwertmeldungen zu übertragen, tritt zusätzlich noch die Problematik auf, den Schalter S nach Figur 1 so zu betätigen, daß die durch einen Puls von $p(t)$ repräsentierte Spannungszeitfläche $U_{ref} \cdot T_0$ auch exakt umgesetzt wird. In jedem anderen Fall ergibt sich neben einem Fehler im Übertragungsbeiwert ein nichtlineares Übertragungsverhalten $v_x = f(U_x)$.

Die Genauigkeitsprobleme des Wandlers nach Figur 1 resultieren zum einen aus der hohen Schaltfrequenz, die wiederum eine Folge davon ist, daß sich die Mittelung bzw. die Interpolation über das gesamte Meßintervall von $u_x = 0$ bis $u_x = u_{ref}$ erstreckt. Diese aufgezeigte Problematik hinsichtlich der Genauigkeit entspannt sich wesentlich, wenn eine Grobquantisierung vorgesehen und nur noch eine Interpolation zwischen jeweils benachbarten Grobquantisierungsstufen durchgeführt wird.

Die Figur 2 zeigt das Prinzip einer entsprechenden Anordnung. Diese in Figur 2 gezeigte erste Ausführungsform des erfindungsgemäßen Analog-Digital-Umsetzers unterscheidet sich vom bekannten Umsetzer gemäß Figur 1 durch die erfindungsgemäße Ausgestaltung des A/D-Wandlers 6.

Als A/D-Wandler 6 gemäß Figur 1 ist nun eine Schaltungsanordnung 16 vorgesehen, die eingangsseitig einen N-Bit-A/D-Wandler 18 mit einem nachgeschalteten digitalen Integrator 20 und einem Zweipunktregler 22 und ausgangsseitig einen Addierer 24 aufweist, dessen Eingänge mit den Ausgängen des digitalen Integrators 20 und des Zweipunktreglers 22 verbunden sind. Der Eingang des N-Bit-A/D-Wandlers 18 und der Eingang des Zweipunktreglers 22 sind miteinander verknüpft. Dadurch gelangt das Ausgangssignal $U_I(t)$ des analogen Integrators 4 jeweils zum N-Bit-A/D-Wandler 18 und zum Zweipunktregler 22.

Der Unterschied zum Umsetzer gemäß Figur 1 ist, daß die rückgekoppelte Spannung $u_r$ im stationären Fall nur maximal um eine Grobquantisierungsstufe Q des D/A-Wandlers 10 neben der analogen Eingangsspannung $u_x$ liegt. Die Schalthandlungen des Zweipunktreglers 22 führen jetzt im Signal $u_r$ nur zu Änderungen in der Größe der Grobquantisierungsstufe Q.

Um die geforderte Genauigkeit zu erzielen, müssen deshalb die einzelnen Quantisierungsstufen des D/A-Wandlers 10 entsprechend genau hergestellt werden.

Wie bereits erwähnt, geht der N-Bit breite A/D-Wandler 18 nicht in die statische Genauigkeit ein, wenn die Integrierzeitkonstante $T_I$ so gewählt wird, daß das Ausgangssignal $U_I$ des Integrators 4 stets kleiner als eine Quantisierungsstufe des A/D-Wandlers 18 ist. Dann liefert der A/D-Wandler an seinem Ausgang im stationären Zustand stets den Wert Null und der Inhalt des digitalen Integrators 20 bleibt unverändert. Dieser Integrator 20 dient zum stationär genauen Ausregeln der Integratorspannung $U_I$ auf den Wert Null.

Übrig bleibt dann nur noch die Arbeitsbewegung, die durch den Zweipunktschalter 22 verursacht wird. Dieser ist notwendig, um das gesamte System, das jetzt zwei in Reihe geschaltete Integratoren 4 und 20 aufweist, zu stabilisieren. Mit diesem Zweipunktschalter 22 wird nämlich ein P-Anteil generiert, so daß sich insgesamt ein PI-Regler ergibt.

Ein wesentlicher Unterschied zu dem Wandler gemäß Figur 1 besteht aber im Aussehen der Folge p(k). Diese Folge p(k) kann jetzt, je nach Anzahl der Quantisierungsstufen ($2^L-1$) des D/A-Wandlers 10 bis zu $2^L$ verschiedene Werte annehmen. Geht man wieder von der Interpolationslänge M aus und berücksichtigt man, daß nur $2^L-1$ Quantisierungsstufen zur Verfügung stehen, ergibt sich die Auflösung in Bit zu

$$\text{Auflösung [Bit]} = \text{ld}\,(M \cdot (2^L - 1)) \tag{11}$$

Mit L = 4 und 12 Bit Auflösung wird jetzt M ≈ 273.

Nachzutragen bleibt noch die erzielbare Genauigkeit. Geht man von den beschriebenen Einstellungen aus, ergibt sich für die Quantisierungsstufe

$$Q = \frac{U_{ref}}{2^L - 1} \tag{12}$$

Somit entspricht der absolute Fehler demjenigen nach Gleichung 10 und man erhält

$$\text{abs.Fehler} = \pm \frac{1}{M \cdot (2^L - 1)} \tag{13}$$

also ± 1 LSB (least significant bit). Dabei wird allerdings von einem exakt arbeitenden D/A-Wandler 10 ausgegangen.

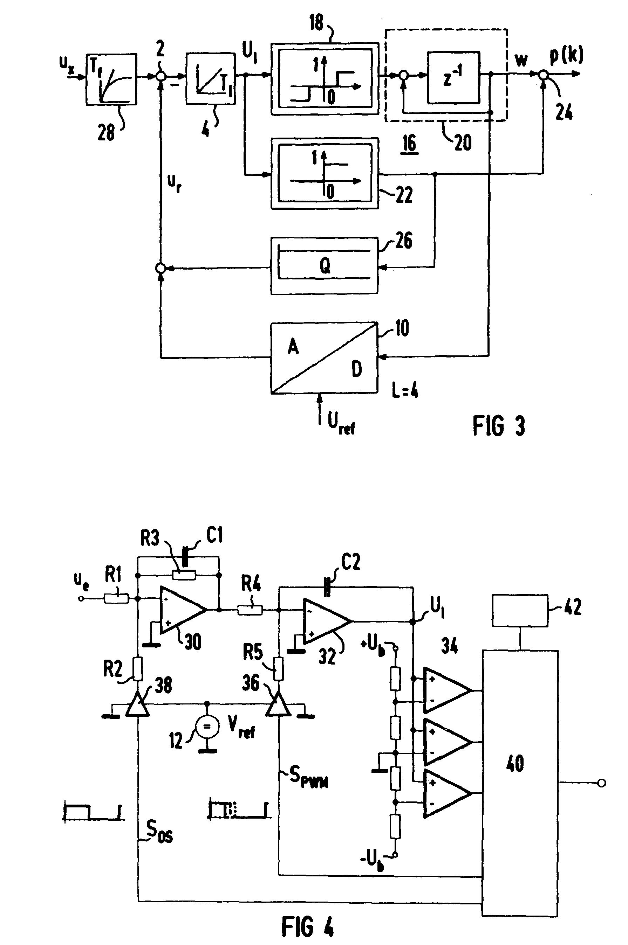

Die Figur 3 zeigt ein Blockschaltbild einer weiteren Ausführungsform des erfindungsgemäßen Umsetzers. Kern ist der Integrator 4, der die Differenz zwischen dem Istwert $u_x$ und dem augenblicklich gültigen Meßwert $u_r$ integriert. Der Ausgang $U_I$ des Integrators 4 wird einem Dreipunktschalter 18 und einem Komparator 22 zugeführt, deren Ausgänge synchron mit einer Frequenz von z.B. 1 MHz abgetastet werden. Die Abtast- und Halteglieder sind in dieser Figur 3 nicht dargestellt. Der abgetastete Ausgangswert des Dreipunktschalters 18 steuert den digitalen Integrator 20, dessen Ausgang sich entsprechend in jedem Takt nur um eins erhöhen oder erniedrigen kann oder konstant bleibt. Das Ausgangssignal des digitalen Integrators 20, dessen Auflösung z.B. 4 Bit beträgt, wird mit Hilfe eines D/A-Wandlers 10 auf den Eingang des Umsetzers zurückgekoppelt. Der 4-Bit D/A-Wandler 10 bestimmt die erreichbare Genauigkeit des gemessenen Spannungsintegrals. Soll dieses mit 12 Bit aufgelöst werden, so muß der D/A-Wandler 10 auf 12 Bit genau sein. Der abgetastete Ausgang des Komparators 22 steuert direkt einen 1-Bit-D/A-Wandler 26, der als P-Glied dargestellt ist, dessen Wertigkeit Q genau einer Quantisierungsstufe des 4-Bit-D/A-Wandlers 10 entspricht.

Im stationären Betrieb (konstantes Eingangssignal) pendelt sich der Ausgang des digitalen Integrators 20 auf einem Wert ein, dessen analoge Darstellung gerade noch kleiner ist als der Istwert. Der Ausgang des Dreipunktschalters 18 liegt dann konstant auf Null. Der Rest der Schaltung wirkt nun wie ein einfacher Sigma-Delta-Wandler erster Ordnung mit 1-Bit-Ausgang, der lediglich die verbleibende Differenz zwischen Istwert und Ausgangswert des digitalen Integrators 20 umwandelt. Das gesamte Wandlungsergebnis, das als Summe aus dem digitalen Integratorausgang und dem Komparatorausgang gebildet wird, wechselt also zwischen den beiden, dem Istwert benachbarten Quantisierungsstufen hin und her. Es steht in der vorgeschlagenen Konfiguration synchron mit dem Abtastintervall von beispielsweise 1 µs zur Verfügung.

Durch eine Aufsummierung dieser Ausgangsgröße über eine Anzahl von Abtastintervallen läßt sich das Integral der Eingangsgröße $u_x$ über ein beliebiges, mit beispielsweise 1 µs Auflösung definiertes Intervall bestimmen. Aufgrund des analogen Integrators 4 im Vorwärtspfad nimmt dabei die Auflösung des Integrals stets zu, so daß aus 4-Bit-Werten nach ca. $2^8 = 256$ Abtastintervallen von beispielsweise 1 µs ein 12-Bit-Wert zur Verfügung steht.

Durch die Verwendung des digitalen Integrators 20, der seinen Ausgang in jedem Takt nur um 1 ändern kann, entsteht eine Begrenzung der zulässigen Anstiegsgeschwindigkeit des Eingangssignals $u_x$. Ein Eingangsfilter 28 mit der Zeitkonstanten $T_f$ begrenzt den Anstieg entsprechend.

Der D/A-Wandler 10 bestimmt die erreichbare Genauigkeit (nicht die Auflösung) des Umsetzers und muß entsprechend auf 12 Bit exakt sein. Als D/A-Wandler 10 kann ein geschaltetes Widerstandsnetzwerk mit der geforderten Genauigkeit und einer Referenzspannungsquelle 12 verwendet werden. Für die D/A-Wandlung des Ausgangssignals des digitalen Integrators 20 werden jedoch nur die höherwertigen 4 Bit verwendet. Der einsynchronisierte Ausgang des Komparators 22 steuert die niederwertigen 8 Bit gemeinsam, so daß seine Wertigkeit insgesamt einer Quantisierungsstufe des digitalen Integrators 20 entspricht. Der D/A-Wandler 10 mit 12 Bit Genauigkeit bildet einen erheblichen Kostenfaktor, da ein derartiger D/A-Wandler 10 nur mit speziellen Herstellungsverfahren realisiert werden kann. Bei einer diskreten ebenso wie bei einer integrierten Realisierung des in Figur 3 gezeigten Umsetzers bestimmt der D/A-Wandler 10 die Kosten des Analogteils maßgeblich.

Als Alternative wird eine Einrichtung zur Erzeugung eines pulsdauermodulierten Signals $S_{PWM}$ aus einem n-Bit-Ausgangssignal w als D/A-Wandler 10 verwendet. Dieses pulsdauermodulierte Signal $S_{PWM}$ läßt sich mittels einer quarzstabilisierten Taktfrequenz hochgenau und mit geringem Aufwand realisieren.

In der Figur 4 ist eine Realisierung einer vorteilhaften Ausführungsform des erfindungsgemäßen Umsetzers dargestellt. Diese Schaltung ist in ein Analogteil und ein Digitalteil aufgeteilt. Der Analogteil besteht aus zwei Operationsverstärkern 30 und 32, drei Komparatoren 34, einer Referenzspannungsquelle 12 und zwei Treibern 36 und 38, insbesondere CMOS-Treiber. Die CMOS-Treiber 36 und 38 werden aus der Referenzspannungsquelle 12 versorgt. Der Operationsverstärker 30 bildet zusammen mit seinen Beschaltungselementen R1, R2, R3 und C1 einen invertierenden Eingangsfilter 28 (Figur 3). Der Operationsverstärker 32 bildet zusammen mit seinen Beschaltungselementen R4, R5 und C2 den Vergleicher 2 mit nachgeschaltetem analogem Integrator 4 (Figur 3). Der als N-Bit-A/D-Wandler 18 verwendete Dreipunktregler und der Zweipunktregler 22 sind durch die drei Komparatoren 34 realisiert.

Um ein bipolares Rückkopplungssignal zu erzeugen, ist normalerweise eine bipolare Referenzspannungsquelle erforderlich. Um dennoch mit einer unipolaren Referenzspannung $V_{ref}$ auszukommen, wird ein zweites PWM-Signal $S_{OS}$ erzeugt, das der digitalen Darstellung des Eingangssignals Null entspricht. Die beiden PWM-Signale $S_{PWM}$ und $S_{OS}$ werden voneinander subtrahiert. Durch diesen symmetrischen Aufbau wird gleichzeitig der durch unterschiedliches Schaltverhalten bei positiven und negativen Flanken entstehende Offset-Fehler eliminiert, da er in beiden Signalen in gleicher Höhe auftritt. Es verbleibt nur die Abweichung zwischen den CMOS-Schaltern 36 und 38 für die PWM-Signale $S_{PWM}$ und $S_{OS}$. Weitgehend eliminiert werden auch die Ungenauigkeiten aufgrund unterschiedlichen Durchlaßverhaltens im oberen und unteren Teil der komplementären CMOS-Ausgänge, da ein Strom jeweils nur durch die oberen Transistoren fließt. Wird ein invertierendes Eingangsfilter verwendet, so kann dieses gleichzeitig zur Subtraktion des zweiten PWM-Signals $S_{OS}$ eingesetzt werden. Da auch hier nur der Mittelwert interessiert, stört die Filterung nicht.

Der Digitalteil dieses Umsetzers laßt sich in Form einer kundenspezifischen integrierten Schaltung 40, auch ASIC genannt, realisieren. Dieser Digitalbaustein 40 beinhaltet den digitalen Integrator 20, den Addierer 24 und eine Einrichtung zur Erzeugung der pulsdauermodulierten Signale $S_{PWM}$ und $S_{OS}$. Diese Schaltung 40 ist mit einem Quarzoszillator 42 und den drei Komparatoren 34 eingangsseitig verknüpft. Ausgangsseitig ist diese Schaltung 40 mit den beiden CMOS-Treibern 36 und 38 verknüpft und weist einen digitalen 4-Bit-Ausgang auf. Selbstverständlich kann auch die gesamte Schaltung (Analog- u. Digitalteil) als ASIC realisiert werden.

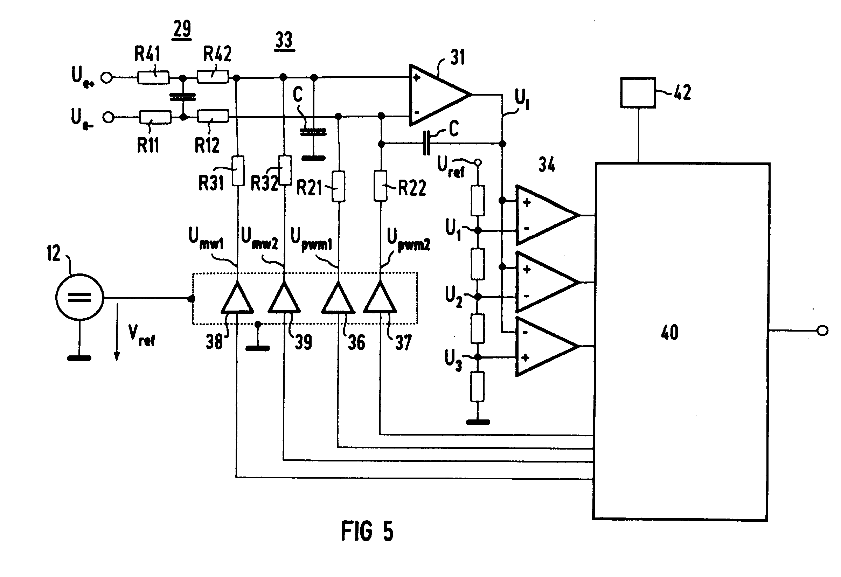

In der Figur 5 ist eine Realisierung einer besonders vorteilhaften Ausführungsform des erfindungsgemäßen Umsetzers dargestellt. Auch diese Schaltung ist in ein Analogteil und ein Digitalteil aufgeteilt. Der Analogteil besteht aus einem Differenz-Integrator 33, drei Komparatoren 34, einer Referenzspannungsquelle 12 und vier Treibern 36, 37, 38 und 39. Diese Treiber 36 bis 39, insbesondere CMOS-Treiber, werden aus der Referenzspannungsquelle 12 versorgt. Der Differenz-Integrator 33 besteht aus einem Operationsverstärker 31 mit seinen Beschaltungselementen C, $R_{21}$, $R_{22}$, $R_{31}$ und $R_{32}$ und aus einem Filter 29, der die Elemente $R_{11}$, $R_{12}$, $R_{41}$, $R_{42}$ und C aufweist. Der Ausgang dieses Differenz-Integrators 33 ist jeweils mit dem nichtinvertierenden Eingang der drei Komparatoren 34 verknüpft.

Der Digitalteil ist durch den bereits erwähnten Digitalbaustein 40 realisiert. Dieser Digitalbaustein 40 beinhaltet den digitalen Integrator 20 und den Addierer 24 der Figur 3 und eine Einrichtung zur Erzeugung mehrerer pulsdauermodulierter Signale $S_{PWM1}$, $S_{PWM2}$, $S_{OS1}$ und $S_{OS2}$. Diese Schaltung 40 ist ebenfalls mit einem Quarzoszillator 42 und den drei Komparatoren 34 eingangsseitig verknüpft. Ausgangsseitig ist dieser Digitalbaustein 40 mit den vier Treibern 36, 37, 38 und 39 verknüpft und weist einen digitalen 4-Bit-Ausgang auf. Bevorzugte Ausführungsform dieses Digitalbausteins 40 ist ein ASIC. Bei einer besonders vorteilhaften Ausführungsform ist in einem solchen ASIC auch der Analogteil integriert.

Gegenüber der Ausführungsform gemäß Figur 4 wird ein Operationsverstärker eingespart und man benötigt keine negative Versorgungsspannung mehr für die Komparatorschaltung. Außerdem erhält man einen voll differentiellen Eingang. Die beiden pulsdauermodulierten Signale $S_{PWM}$ und $S_{OS}$ (Rückmeldung des Meßwertes und Nullpunkt-Information) werden jeweils aus zwei pulsdauermodulierten Signalen $S_{PWM1}$, $S_{PWM2}$ und $S_{OS1}$, $S_{OS2}$ zusammengesetzt. Dadurch wird das Nullpunkt-Signal, also der Mittelwert der beiden Signale $U_{mw1}$ und $U_{mw2}$, frei von Sprüngen und das Meßsignal - Mittelwert der beiden Signale $U_{pwm1}$ und $U_{pwm2}$ - weist nur noch Sprünge um die halbe Referenzspannung $V_{ref}$ auf. Beides kommt einer Realisierung mit einfachen Komponenten und damit einer Integration in einem ASIC sehr entgegen. Dadurch wird der ASIC noch preiswerter.

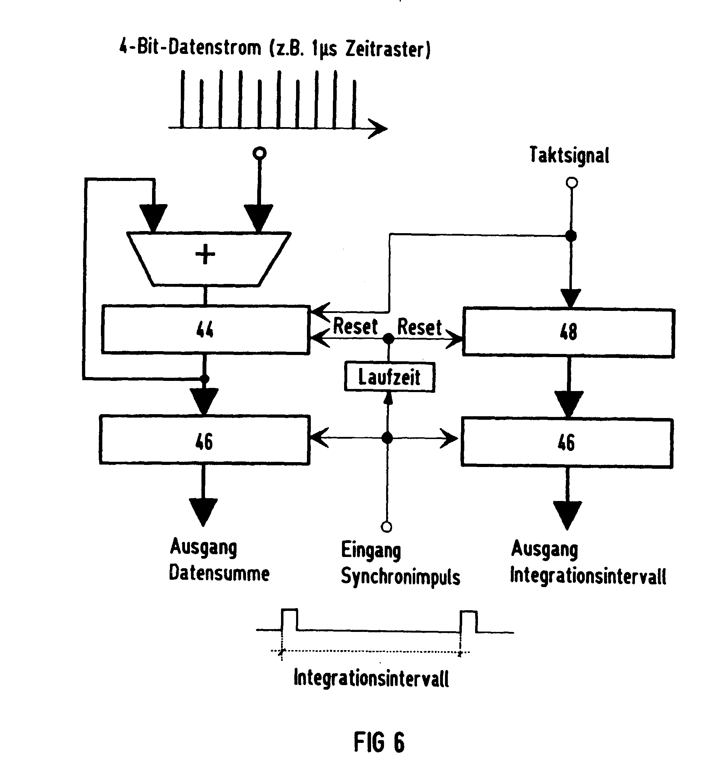

Das bisher beschriebene Umsetzsystem liefert im Zeitraster der Abtastperiode (z.B. 1 us) Meßwerte mit geringer Auflösung (z.B. 4 Bit), die durch weitere digitale Verarbeitungsschritte aufbereitet werden. In dem bekannten Sigma-Delta-A/D-Umsetzer erfolgt dies durch mehrstufige digitale Filterung. Für den vorliegenden Anwendungszweck (Antriebstechnik), wird die digitale Filterung am einfachsten durch eine Mittelwertbildung mit variablen Grenzen realisiert, deren Blockschaltbild in Figur 6 naher dargestellt ist. Dazu werden die anfallenden Daten laufend in einem Akkumulator 44 aufsummiert. Durch ein Synchronisiersignal, das jeweils den Start eines neuen Integrationsintervalls anzeigt, wird die Summe in einen Speicher 46 übertragen und dann der Akkumulator 44 zurückgesetzt. Parallel dazu mißt ein Zeitzähler 48 das Integrationsintervall. Der endgültige Meßwert entsteht als Quotient aus Datensumme und Integrationszeit.

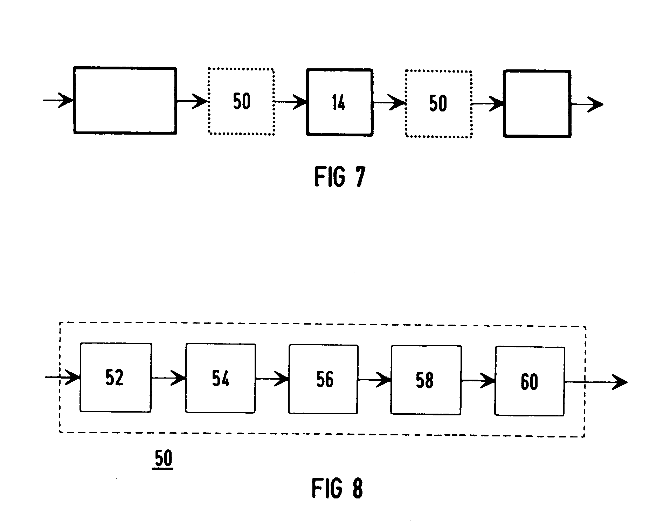

Für ein System zur dezentralen Istwerterfassung gemäß Figur 7 ist eine serielle Datenübertragung wünschenswert, um den Verdrahtungsaufwand zu reduzieren. Dadurch wird auch der Einsatz einer optischen Datenübertragung zur Potentialtrennung und Erhöhung der Störsicherheit möglich. Eine serielle Datenübertragung 50 kann zwischen den Ausgang des erfindungsgemäßen Umsetzers und die nachfolgende Filterung oder zwischen Teile der nachfolgenden Filterung eingefügt werden (Figur 7). Die Komponenten vor der seriellen Übertragung lassen sich dann dezentral verteilen.

Die serielle Datenübertragung 50 gemäß Figur 8 besteht aus der Parallel-Seriell-Datenwandlung 52, aus einer geeigneten Kodierung 54, die die Synchronisation von Sender und Empfänger erlaubt, einer Übertragungsstrecke 56 (z.B. optischer Sender, Lichtleiter, optischer Empfänger), einer Dekodierung 58 und einer Seriell-Parallel-Datenwandlung 60. Kodierung und Parallel-Seriell-Datenwandlung können auch in umgekehrter Reihenfolge oder in einer Stufe erfolgen, entsprechendes gilt für die Empfängerseite.

Mittels dieser seriellen Datenübertragung für eine dezentrale Istwerterfassung kann das analoge Eingangssignal $u_x$ bereits dezentral auf feste Grenzwerte überwacht werden. Die digitale Information einer Grenzwertüberschreitung kann in das serielle Datenübertragungsprotokoll dieser seriellen Datenübertragung eingefügt werden.

Alternativ zu einer Seriell-Parallel-Wandlung mit anschließender Aufsummierung der parallelen Daten kann auch direkt eine serielle Aufsummierung erfolgen. Dabei werden die seriell anfallenden Daten ihrer Wertigkeit unterschiedlichen Eingängen eines Zählers zugeführt. Auch diese Variante kann mit festen oder variablen Zeitgrenzen arbeiten, wenn der Zähler durch ein Synchronisierungssignal jeweils zurückgesetzt wird. Die Weiterverarbeitung zum Mittelwert im vorgegebenen Meßintervall erfolgt wie zuvor durch Division von Datensumme und Meßdauer.

Das beschriebene System weist die typischen Eigenschaften der integrierten Istwerterfassung auf. Es ist nahezu vollständig digitalisiert, mit geringem Aufwand zu realisieren und dabei robust, störsicher und zuverlässig. Es eignet sich zudem besser für eine Integration als mixed-signal-ASIC. Das System eignet sich auch hervorragend für eine dezentrale Istwerterfassung. Dabei läßt sich die Übertragungsdatenrate in weiten Grenzen wählen, indem auf der dezentralen Seite eine Vorverarbeitung durch einfache Addition einer festen Anzahl von 4-Bit-Meßwerten vorgenommen wird. Werden z.B. vier Meßwerte zusammengefaßt, so müssen im Zeitraster von 4 µs Meßwerte von 6 Bit Auflösung übertragen werden.

**Patentansprüche**

1. Integrierender Analog-Digital-Umsetzer, der eine Reihenschaltung eines analogen Integrators (4), eines A/D-Wandlers (6) und einer synchronen Abtastung (8) aufweist, wobei die Reihenschaltung eingangsseitig mit einem Ausgang eines Vergleichers (2) und ausgangsseitig über einen D/A-Wandler (10) mit einem negativen Eingang dieses Vergleichers (2) verbunden ist, an dessen positivem Eingang eine analoge Eingangsgröße ($u_x$) ansteht, **dadurch gekennzeichnet**, daß als A/D-Wandler (6) eine Schaltungsanordnung (16) vorgesehen ist, die eingangsseitig einen N-Bit-A/D-Wandler (18) mit nachgeschaltetem digitalen Integrator (20) und einen Zweipunktregler (22) und ausgangsseitig einen Addierer (24) aufweist, dessen Eingänge mit den Ausgängen des digitalen Integrators

(20) und des Zweipunktreglers (22) verbunden sind, wobei die Eingänge des N-Bit-A/D-Wandlers (18) und des Zweipunktreglers (22) miteinander verknüpft sind.

2. Integrierender Analog-Digital-Umsetzer nach Anspruch 1, **dadurch gekennzeichnet**, daß der Ausgang des Zweipunktreglers (22) außerdem mittels eines 1-Bit-D/A-Wandlers (26) mit dem negativen Eingang des Vergleichers (2) und der D/A-Wandler (10) eingangsseitig mit dem Ausgang des digitalen Integrators (20) verbunden ist.

3. Integrierender Analog-Digital-Umsetzer nach Anspruch 1, **dadurch gekennzeichnet**, daß als D/A-Wandler (10) eine Einrichtung zur Erzeugung eines pulsdauermodulierten Signals ($S_{PWM}$) aus einem n-Bit-Ausgangssignal (w) vorgesehen ist.

4. Integrierender Analog-Digital-Umsetzer nach Anspruch 1, **dadurch gekennzeichnet**, daß als N-Bit-A/D-Wandler (18) ein Dreipunktregler vorgesehen ist.

5. Integrierender Analog-Digital-Umsetzer nach Anspruch 1, **dadurch gekennzeichnet**, daß als N-Bit-A/D-Wandler (18) ein Fünfpunktregler vorgesehen ist.

6. Integrierender Analog-Digital-Umsetzer nach Anspruch 2, **dadurch gekennzeichnet**, daß als 1-Bit-D/A-Wandler (26) ein Analogschalter vorgesehen ist.

7. Integrierender Analog-Digital-Umsetzer nach Anspruch 4, **dadurch gekennzeichnet**, daß der Dreipunktregler (18) aus drei Komparatoren besteht, deren positive Eingänge parallel geschaltet sind und an deren negativen Eingängen jeweils eine Referenzspannung ansteht.

8. Integrierender Analog-Digital-Umsetzer nach Anspruch 5, **dadurch gekennzeichnet**, daß der Fünfpunktregler aus fünf Komparatoren besteht, deren positive Eingänge parallel geschaltet sind und an deren negativen Eingängen jeweils eine Referenzspannung ansteht.

9. Integrierender Analog-Digital-Umsetzer nach den Ansprüchen 1 bis 3, **dadurch gekennzeichnet**, daß der digitale Integrator (20), der Zweipunktregler (22) und die Einrichtung zur Erzeugung eines pulsdauermodulierten Signals ($S_{PWM}$) in einem Digitalbaustein (40) integriert sind.

10. Integrierender Analog-Digital-Umsetzer nach Anspruch 9, **dadurch gekennzeichnet**, daß als Digitalbaustein (40) ein ASIC vorgesehen ist.

11. Integrierender Analog-Digital-Umsetzer nach den Ansprüchen 1 bis 3, **dadurch gekennzeichnet**, daß dieser integrierende Analog-Digital-Umsetzer in einem ASIC integriert ist.

12. Integrierender Analog-Digital-Umsetzer nach Anspruch 11, **dadurch gekennzeichnet**, daß der ASIC einen Analogteil, bestehend aus zwei Operationsverstärkern (30, 32), wenigstens drei Komparatoren (34), einer Referenzquelle (12), zwei Treibern (36, 38) und einem Digitalteil, bestehend aus einem Digitalbaustein (40) und einem Oszillator (42), aufweist, wobei der Digitalbaustein (40) eingangsseitig mit den Komparatoren (34) und ausgangsseitig mit den Treibern (36, 38) verknüpft ist, wobei ein weiterer Ausgang des Digitalbausteins (40) einen Ausgang des ASIC bildet.

13. Integrierender Analog-Digital-Umsetzer nach Anspruch 11, **dadurch gekennzeichnet**, daß der ASIC einen Analogteil, bestehend aus einem Differenz-Integrator (33), wenigstens drei Komparatoren (34), einer Referenzspannnungsquelle (12), vier Treibern (36, 37, 38, 39) und einem Digitalteil, bestehend aus einem Digitalbaustein (40) und einem Oszillator (42), aufweist, wobei der Digitalbaustein (40) eingangsseitig mit den Komparatoren (34) und ausgangsseitig mit den Treibern (36, 37, 38, 39) verknüpft ist, wobei ein weiterer Ausgang des Digitalbausteins (40) einen Ausgang des ASIC bildet.

**Claims**

1. Integrating analog-to-digital converter, which has a series circuit arrangement of an analog integrator (4), an A/D converter (6) and a synchronous scanning unit (8), the input side of the series circuit arrangement being connected to an output of a comparator (2) and the output side being connected by way of a D/A converter (10) to a negative input of this comparator (2), at the positive input of which an analog input variable ($u_x$) is present, characterised in that there is provided as an A/D converter (6) a circuit arrangement (16) which has, on the input side, an N-bit A/D converter (18), having a downstream digital integrator (20), and a two-position controller (22) and, on the output side, an adder (24), the inputs of which are connected to the outputs of the digital integrator (20) and of the two-position controller (22), the inputs of the N-bit A/D converter (18) and those of the two-position controller (22) being connected to each other.

2. Integrating analog-to-digital converter according to claim 1, characterised in that the output of the two-position controller (22) is also connected by means of a 1-bit D/A converter (26) to the negative input of the comparator (2), and the input side of the D/A converter (10) is connected to the output of the digital integrator (20).

3. Integrating analog-to-digital converter according to claim 1, characterised in that there is provided as a D/A converter (10) a device for generating a pulse-width-modulated signal ($S_{PWM}$) from an n-bit output signal (w).

4. Integrating analog-to-digital converter according to claim 1, characterised in that there is provided as an N-bit A/D converter (18) a three-position controller.

5. Integrating analog-to-digital converter according to claim 1, characterised in that there is provided as an N-bit A/D converter (18) a five-position controller.

6. Integrating analog-to-digital converter according to claim 2, characterised in that there is provided as a 1-bit D/A converter (26) an analog switch.

7. Integrating analog-to-digital converter according to claim 4, characterised in that the three-position controller (18) comprises three comparators, the positive inputs of which are connected in parallel and at the negative inputs of which a respective reference voltage is present.

8. Integrating analog-to-digital converter according to claim 5, characterised in that the five-position controller comprises five comparators, the positive inputs of which are connected in parallel and at the negative inputs of which a respective reference voltage is present.

9. Integrating analog-to-digital converter according to claims 1 to 3, characterised in that the digital integrator (20), the two-position controller (22) and the device for generating a pulse-width-modulated signal ($S_{PWM}$) are integrated in a digital module (40).

10. Integrating analog-to-digital converter according to claim 9, characterised in that there is provided as a digital module (40) an ASIC.

11. Integrating analog-to-digital converter according to claims 1 to 3, characterised in that this integrating analog-to-digital converter is integrated in an ASIC.

12. Integrating analog-to-digital converter according to claim 11, characterised in that the ASIC has an analog portion comprising two operational amplifiers (30, 32), at least three comparators (34), one reference source (12) and two drivers (36, 38), and a digital portion comprising a digital module (40) and an oscillator (42), the input side of the digital module (40) being connected to the comparators (34) and the output side being connected to the drivers (36, 38), with a further output of the digital module (40) forming an output of the ASIC.

13. Integrating analog-to-digital converter according to claim 11, characterised in that the ASIC has an analog portion comprising a differential integrator (33), at least three comparators (34), one reference voltage source (12) and four drivers (36, 37, 38, 39), and a digital portion comprising a digital module (40) and an oscillator (42), the input side of the digital module (40) being connected to the comparators (34) and the output side being connected to the drivers (36, 37, 38, 39), with a further output of the digital module (40) forming an output of the ASIC.

**Revendications**

1. Convertisseur analogique-numérique à intégration, qui comporte un circuit série formé d'un intégrateur analogique (4), d'un convertisseur analogique-numérique (6) et d'un échantillonneur synchrone (8), le circuit série étant relié en entrée à une sortie d'un comparateur (2) et en sortie par l'intermédiaire d'un convertisseur numérique-analogique (10) à une entrée négative de ce comparateur (2) dont l'entrée positive reçoit une grandeur d'entrée analogique ($u_x$),

caractérisé par le fait qu'il est prévu comme convertisseur analogique-numérique (6) un circuit (16) qui comporte en entrée un convertisseur analogique-numérique à N bits (18), avec un intégrateur numérique (20) branché du côté aval, et un régulateur à deux positions (22) et en sortie un additionneur (24) dont les entrées sont reliées aux sorties de l'intégrateur numérique (20) et du régulateur à deux positions (22), les entrées du convertisseur analogique-numérique à N bits (18) et du régulateur à deux positions (22) étant reliées.

2. Convertisseur analogique-numérique à intégration selon la revendication 1, caractérisé par le fait que la sortie du régulateur à deux positions (22) est reliée en outre au moyen d'un convertisseur numérique-analogique à 1 bit (26) à l'entrée négative du comparateur (2) et le convertisseur numérique-analogique (10) est relié en entrée à la sortie de l'intégrateur numérique (20).

3. Convertisseur analogique-numérique à intégration selon la revendication 1, caractérisé par le fait qu'il est prévu comme convertisseur numérique-analogique (10) un dispositif destiné à produire un signal à modulation de durée d'impulsion ($S_{PWM}$) à partir d'un signal de sortie à n bits (w).

4. Convertisseur analogique-numérique à intégration selon la revendication 1, caractérisé par le fait qu'il est prévu comme convertisseur analogique-numérique à N bits (18) un régulateur à trois positions.

5. Convertisseur analogique-numérique à intégration selon la revendication 1, caractérisé par le fait qu'il est prévu comme convertisseur analogique-numérique à N bits (18) un régulateur à cinq positions.

6. Convertisseur analogique-numérique à intégration selon la revendication 2, caractérisé par le fait qu'il est prévu comme convertisseur numérique-analogique à 1 bit (26) un interrupteur analogique.

7. Convertisseur analogique-numérique à intégration selon la revendication 4, caractérisé par le fait que le régulateur à trois positions (18) est constitué de trois comparateurs dont les entrées positives sont branchées en parallèle et dont les entrées négatives reçoivent une tension de référence.

8. Convertisseur analogique-numérique à intégration selon la revendication 5, caractérisé par le fait que le régulateur à cinq positions (18) est constitué de cinq comparateurs dont les entrées positives sont branchées en parallèle et dont les entrées négatives reçoivent une tension de référence.

9. Convertisseur analogique-numérique à intégration selon les revendications 1 à 3, caractérisé par le fait que l'intégrateur numérique (20), le régulateur à deux positions (22) et le dispositif destiné à produire un signal à modulation de durée d'impulsion ($S_{PWM}$) sont intégrés dans un composant numérique (40).

10. Convertisseur analogique-numérique à intégration selon la revendication 9, caractérisé par le fait qu'il est prévu comme composant numérique (40) un ASIC.

11. Convertisseur analogique-numérique à intégration selon les revendications 1 à 3, caractérisé par le fait que ce convertisseur analogique-numérique à intégration est intégré dans un ASIC.

12. Convertisseur analogique-numérique à intégration selon la revendication 11, caractérisé par le fait que l'ASIC comporte une partie analogique, constituée de deux amplificateurs opérationnels (30, 32), d'au moins trois comparateurs (34), d'une source de référence (12) et de deux circuits d'attaque (36, 38), et une partie numérique, constituée d'un composant numérique (40) et d'un oscillateur (42), le composant numérique (40) étant relié en entrée aux comparateurs (34) et en sortie aux circuits d'attaque (36, 38), une autre sortie du composant numérique (40) constituant une sortie de l'ASIC.

13. Convertisseur analogique-numérique à intégration selon la revendication 11, caractérisé par le fait que l'ASIC comporte une partie analogique, constituée d'un intégrateur différentiel (33), d'au moins trois comparateurs (34), d'une source de tension de référence (12) et de quatre circuits d'attaque (36, 37, 38, 39), et une partie numérique, constituée d'un composant numérique (40) et d'un oscillateur (42), le composant numérique (40) étant relié en entrée aux comparateurs (34) et en sortie aux circuits d'attaque (36, 37, 38, 39), une autre sortie du composant numérique (40) constituant une sortie de l'ASIC.

FIG 1

FIG 2

FIG 3

FIG 4

FIG 5

4-Bit-Datenstrom (z.B. 1μs Zeitraster)

Taktsignal

+

44

Reset Reset

48

Laufzeit

46

46

Ausgang
Datensumme

Eingang
Synchronimpuls

Ausgang
Integrationsintervall

Integrationsintervall

FIG 6

FIG 7

50

FIG 8